(19) Europäisches Patentamt
European Patent Office
Office européen des brevets

(11) **EP 3 982 431 B1**

(12) **EUROPEAN PATENT SPECIFICATION**

(45) Date of publication and mention
of the grant of the patent:
**04.03.2026 Bulletin 2026/10**

(21) Application number: **20819123.9**

(22) Date of filing: **28.05.2020**

(51) International Patent Classification (IPC):
***H10N 10/13*** *(2023.01)*     ***H10N 10/17*** *(2023.01)*

(52) Cooperative Patent Classification (CPC):
**H10N 10/13; H10N 10/17**

(86) International application number:
**PCT/KR2020/006946**

(87) International publication number:
**WO 2020/246749 (10.12.2020 Gazette 2020/50)**

(54) **THERMOELECTRIC DEVICE**

THERMOELEKTRISCHE VORRICHTUNG

DISPOSITIF THERMOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.06.2019 KR 20190066648**

(43) Date of publication of application:
**13.04.2022 Bulletin 2022/15**

(73) Proprietor: **LG Innotek Co., Ltd.**
**Seoul 07796 (KR)**

(72) Inventors:
• **CHOI, Man Hue**
**Seoul 07796 (KR)**

• **CHO, Yong Sang**
**Seoul 07796 (KR)**

(74) Representative: **Plasseraud IP**
**104 Rue de Richelieu**
**CS92104**
**75080 Paris Cedex 02 (FR)**

(56) References cited:
**WO-A1-2012/140652**    **JP-A- 2002 280 621**
**JP-A- 2002 280 621**    **JP-A- 2009 188 088**
**JP-A- 2009 188 088**    **JP-A- 2012 049 534**
**JP-A- 2012 049 534**    **JP-A- H10 144 967**
**JP-A- H10 144 967**    **KR-A- 20080 089 926**
**KR-A- 20080 089 926**    **US-A1- 2013 014 795**
**US-A1- 2018 094 823**

**Description**

[Technical Field]

The present invention relates to a thermoelectric device, and more specifically, to a substrate and an insulating layer of a thermoelectric device.

[Background Art]

A thermoelectric effect is a phenomenon occurring due to movement of electrons and holes in a material, and the thermoelectric effect means direct energy conversion between heat and electricity.

A thermoelectric device is a generic term for devices using a thermoelectric effect and has a structure in which P-type thermoelectric legs and N-type thermoelectric legs are bonded between metal electrodes to form PN junction pairs.

Thermoelectric devices may be divided into devices using a change in electrical resistance according to a change in temperature, devices using the Seebeck effect in which an electromotive force is generated due to a difference in temperature, devices using the Peltier effect in which heat absorption or heating occurs due to a current, and the like.

The thermoelectric devices have been variously applied to home appliances, electronic components, communication components, and the like. For example, the thermoelectric devices may be applied to cooling apparatuses, heating apparatuses, power generation apparatuses, and the like. Therefore, the demand for thermoelectric performance of the thermoelectric device is gradually increasing.

A thermoelectric device includes substrates, electrodes, and thermoelectric legs, a plurality of thermoelectric legs are disposed between an upper substrate and a lower substrate, a plurality of upper electrodes are disposed between the plurality of thermoelectric legs and the upper substrate, and a plurality of lower electrodes are disposed between the plurality of thermoelectric legs and the lower substrate.

In order to improve the heat transfer performance of the thermoelectric device, attempts to use a metal substrate are increasing.

Generally, a thermoelectric device may be manufactured through a process of sequentially depositing a resin layer, electrodes, and thermoelectric legs on a prepared metal substrate. When the metal substrate is used, although an advantageous effect may be obtained in terms of heat conduction, there is a problem in that reliability is degraded due to a low withstand voltage when used for a long time.

Documents KR 2008/0089926 A and JP 2009/188088 A disclose examples of thermoelectric devices implementing such metal substrates.

In order to solve the problem, although there is an attempt to increase the withstand voltage by oxidizing a surface of the metal substrate, since a heat sink should be bonded to the substrate at a high temperature portion side, there is a problem in that it is difficult to bond the oxidized metal substrate and the heat sink.

Accordingly, a thermoelectric device with improved not only heat conduction performance but also withstand voltage performance and bonding performance of a heat sink is required.

[Disclosure]

[Technical Problem]

The present invention is directed to providing a structure of a substrate and an insulating layer of a thermoelectric device with improved all heat conduction performance, withstand voltage performance, and bonding performance of a heat sink.

[Technical Solution]

To this end, the invention relates to a thermoelectric device according to claim 1.

The thermoelectric device may present one or more of the features of the dependent claims, in any technically feasible combination.

[Advantageous Effects]

According to the embodiment of the present invention, a thermoelectric device having high performance and high reliability can be obtained. Particularly, according to the embodiment of the present invention, a thermoelectric device with improved not only heat conduction performance but also withstand voltage performance and bonding performance with a heat sink can be obtained.

In addition, according to the embodiment of the present invention, a thermoelectric device, which satisfies a difference in performance between a low temperature portion and a high temperature portion, can be obtained.

The thermoelectric device according to the embodiment of the present invention can be applied to not only applications formed in small sizes but also applications formed in large sizes, such as vehicles, ships, steel mills, incinerators, and the like.

[Description of Drawings]

FIG. 1 shows cross-sectional views illustrating thermoelectric devices, and FIG. 2 is a perspective view illustrating a thermoelectric device.
FIG. 3 is a perspective view illustrating a thermoelectric device including a sealing member.
FIG. 4 is an exploded perspective view illustrating the thermoelectric device including the sealing member.
FIG. 5 is a cross-sectional view illustrating a thermoelectric device according to one embodiment of the present invention.
FIG. 6 is a cross-sectional view illustrating a thermoelectric device according to another embodiment of the present invention.
FIG. 7 is a cross-sectional view illustrating a thermoelectric device according to still another embodiment of the present invention.
FIG. 8 is a cross-sectional view illustrating a thermoelectric device according to yet another embodiment of the present invention, and FIG. 9 is a cross-sectional view illustrating a thermoelectric device according to yet another embodiment of the present invention.
FIG. 10 is a graph showing a result of simulating a withstand voltage according to a thickness of an insulating layer.
FIG. 11 is a graph showing a result of simulating a change in thermal resistance according to a thickness of an insulating layer in each structure of Comparative Example, Example 2, and Example 3.

[Modes of the Invention]

Hereinafter, exemplary embodiments of the present invention will be described in detail with reference to the accompanying drawings.

In addition, unless clearly and specifically defined otherwise by context, all terms (including technical and scientific terms) used herein can be interpreted as having customary meanings to those skilled in the art, and meanings of generally used terms, such as those defined in commonly used dictionaries, will be interpreted by considering contextual meanings of the related technology.

In addition, the terms used in the embodiments of the present invention are considered in a descriptive sense and not for limiting the present invention.

In the present specification, unless clearly indicated otherwise by the context, singular forms include the plural forms thereof, and in a case in which "at least one (or one or more) among A, B, and C" is described, this may include at least one combination among all possible combinations of A, B, and C.

In addition, in descriptions of components of the present invention, terms such as "first," "second," "A," "B," "(a)," and "(b)" can be used.

The terms are only to distinguish one element from another element, and an essence, order, and the like of the element are not limited by the terms.

In addition, it should be understood that, when an element is referred to as being "connected or coupled" to another element, such a description may include both a case in which the element is directly connected or coupled to another element and a case in which the element is connected or coupled to another element with still another element disposed therebetween.

In addition, in a case in which any one element is described as being formed or disposed "on or under" another element, such a description includes both a case in which the two elements are formed or disposed in direct contact with each other and a case in which one or more other elements are disposed between the two elements. In addition, when one element is described as being disposed "on or under" another element, such a description may include a case in which the one element is disposed at an upper side or a lower side with respect to another element.

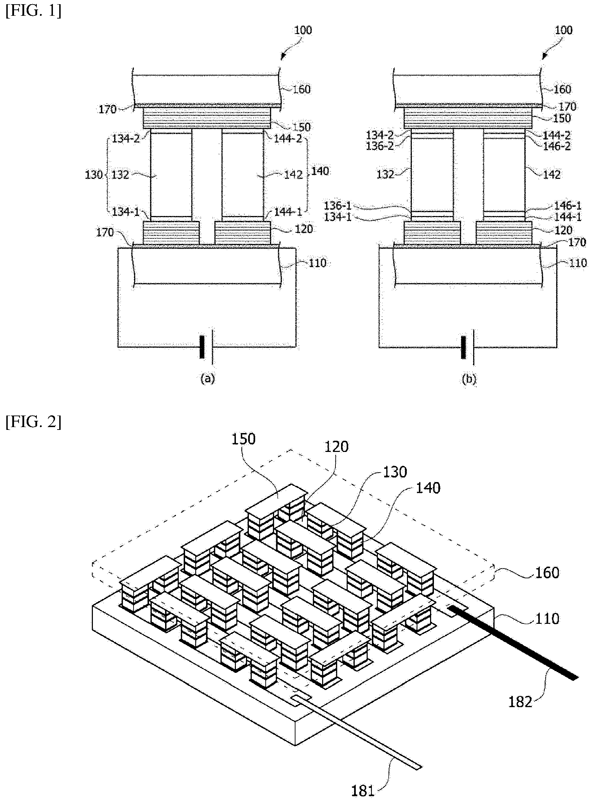

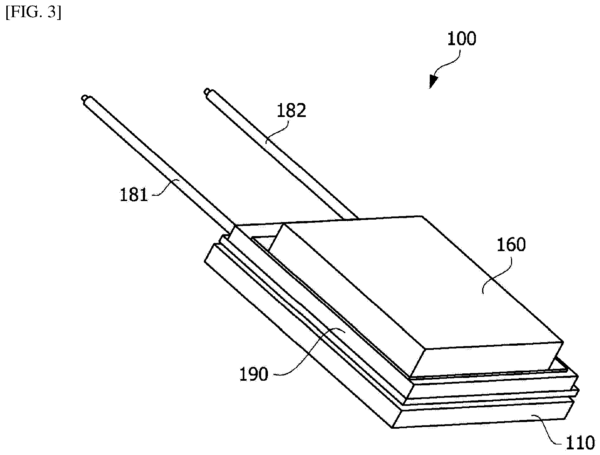

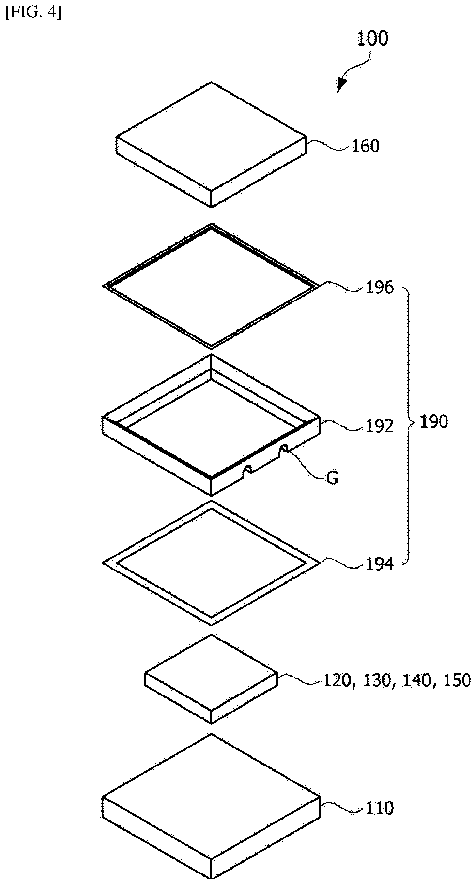

FIG. 1 shows cross-sectional views illustrating thermoelectric devices, and FIG. 2 is a perspective view illustrating a thermoelectric device. FIG. 3 is a perspective view illustrating a thermoelectric device including a sealing member, and FIG. 4 is an exploded perspective view illustrating the thermoelectric device including the sealing member.

Referring to FIGS. 1 and 2, a thermoelectric device 100 includes a lower substrate 110, lower electrodes 120, P-type thermoelectric legs 130, N-type thermoelectric legs 140, upper electrodes 150, and an upper substrate 160.

The lower electrodes 120 are disposed between the lower substrate 110 and lower surfaces of the P-type thermoelectric legs 130 and the N-type thermoelectric legs 140, and the upper electrodes 150 are disposed between the upper substrate 160 and upper surfaces of the P-type thermoelectric legs 130 and the N-type thermoelectric legs 140. Accordingly, the plurality of P-type thermoelectric legs 130 and the plurality of N-type thermoelectric legs 140 are electrically connected through the lower electrodes 120 and the upper electrodes 150. A pair of the P-type thermoelectric leg 130 and the N-type thermoelectric leg 140 disposed between the lower electrodes 120 and the upper electrode 150 and electrically connected to each other may form a unit cell.

For example, when a voltage is applied to the lower electrodes 120 and the upper electrodes 150 through lead wires 181 and 182, due to the Peltier effect, the substrate, through which a current flows from the P-type thermoelectric leg 130 to the N-type thermoelectric leg 140, may absorb heat to serve as a cooling portion, and the substrate, through which a current flows from the N-type thermoelectric leg 140 to the P-type thermoelectric leg 130, may be heated to serve as a heating portion. Alternatively, when a temperature difference is applied between the lower electrode 120 and the upper electrode 150, due to the Seebeck effect, electric charges may be moved through the P-type thermoelectric legs 130 and the N-type thermoelectric leg 140 so that electricity may be generated.

In this case, each of the P-type thermoelectric leg 130 and the N-type thermoelectric leg 140 may be a bismuth-telluride (Bi-Te)-based thermoelectric leg mainly including Bi and Te. The P-type thermoelectric leg 130 may be the Bi-Te-based thermoelectric leg including at least one among antimony (Sb), nickel (Ni), aluminum (Al), copper (Cu), silver (Ag), lead (Pb), boron (B), gallium (Ga), Te, Bi, and indium (In). For example, the P-type thermoelectric leg 130 may include Bi-Sb-Te, which is a main material, at 99 to 99.999 wt% and at least one among Ni, Al, Cu, Ag, Pb, B, Ga, and In at 0.001 to 1 wt% based on a total weight of 100 wt%. The N-type thermoelectric leg 140 may be the Bi-Te-based thermoelectric leg including at least one among Se, Ni, Cu, Ag, Pb, B, Ga, Te, Bi, and In. For example, the N-type thermoelectric leg 140 may include Bi-Se-Te, which is a main material, at 99 to 99.999 wt% and at least one among Ni, Al, Cu, Ag, Pb, B, Ga, and In at 0.001 to 1 wt% based on a total weight of 100 wt%.

Each of the P-type thermoelectric leg 130 and the N-type thermoelectric leg 140 may be formed in a bulk type or stack type. Generally, the bulk type P-type thermoelectric leg 130 or the bulk type N-type thermoelectric leg 140 may be formed through a process in which a thermoelectric material is heat-treated to manufacture an ingot, the ingot is grinded and strained to obtain a powder for a thermoelectric leg, the powder is sintered, and a sintered body is cut. In this case, each of the P-type thermoelectric leg 130 and the N-type thermoelectric leg 140 may be a polycrystalline thermoelectric leg. When the powder for the thermoelectric leg is sintered in order to manufacture the polycrystalline thermoelectric leg, the powder may be compressed at 100 MPa to 200 MPa. For example, when the P-type thermoelectric leg 130 is sintered, the powder for the thermoelectric leg may be sintered at 100 to 150 MPa, preferably at 110 to 140 MPa, and more preferably at 120 to 130 MPa. In addition, when the N-type thermoelectric leg 130 is sintered, the powder for the thermoelectric leg may be sintered at 150 to 200 MPa, preferably at 160 to 195 MPa, and more preferably at 170 to 190 MPa. As described above, when each of the P-type thermoelectric leg 130 and the N-type thermoelectric leg 140 is the polycrystalline thermoelectric leg, strength of the P-type thermoelectric leg 130 and the N-type thermoelectric leg 140 may increase. The stack type P-type thermoelectric leg 130 or the stack type N-type thermoelectric leg 140 may be formed in a process in which a paste containing a thermoelectric material is applied on base members each having a sheet shape to form unit members, and the unit members are stacked and cut.

In this case, the pair of the P-type thermoelectric leg 130 and the N-type thermoelectric leg 140 may have the same shape and volume or may have different shapes and volumes. For example, since electrical conduction properties of the P-type thermoelectric leg 130 and the N-type thermoelectric leg 140 are different, a height or cross sectional area of the N-type thermoelectric leg 140 may be different from that of the P-type thermoelectric leg 130.

In this case, the P-type thermoelectric leg 130 or N-type thermoelectric leg 140 may have a cylindrical shape, a polygonal column shape, an elliptical column shape, or the like.

Alternatively, the P-type thermoelectric leg 130 or the N-type thermoelectric leg 140 may also have a stack type structure. For example, the P-type thermoelectric leg of the N-type thermoelectric leg may be formed using a method in which a plurality of structures, in which a semiconductor material is applied on base members each having a sheet shape, are stacked and cut. Accordingly, material loss may be prevented and an electrical conduction property may be improved. The structures may further include conductive layers having opening patterns, and accordingly, an adhesive force between the structures increases, heat conductivity may decrease, and electric conductivity may increase.

Alternatively, the P-type thermoelectric leg 130 or the N-type thermoelectric leg 140 may be formed so that cross sectional areas are different in one thermoelectric leg. For example, in one thermoelectric leg, cross sectional areas of both end portions disposed toward electrodes are greater than a cross sectional area between the both end portions. Accordingly, since a temperature difference between both end portions may be large, thermoelectric efficiency can be improved.

The performance of the thermoelectric device according to one embodiment of the present invention may be expressed as a thermoelectric performance figure of merit (ZT). The thermoelectric performance figure of merit (ZT) may be expressed by Equation 1.

[Equation 1]

$$ZT = \alpha^2 \cdot \sigma \cdot T/k$$

Here, $\alpha$ denotes the Seebeck coefficient [V/K], $\sigma$ denotes electric conductivity [S/m], and $\alpha^2 \cdot \sigma$ denotes a power factor [W/mK$^2$]. In addition, T denotes temperature, and k denotes thermal conductivity [W/mK]. k may be expressed as a•cp•$\rho$, where a denotes thermal diffusivity [cm$^2$/S], cp denotes specific heat [J/gK], and $\rho$ denotes density [g/cm$^3$].

In order to obtain the thermoelectric performance figure of merit (ZT) of a thermoelectric device, a Z value (V/K) is measured using a Z meter, and thus the thermoelectric performance figure of merit (ZT) may be calculated using the measured Z value.

In this case, each of the lower electrodes 120 disposed between the lower substrate 110 and the P-type thermoelectric leg 130 and the N-type thermoelectric leg 140 and the upper electrodes 150 disposed between the upper substrate 160 and the P-type thermoelectric leg 130 and N-type thermoelectric leg 140 may include at least one among Cu, Ag, Al, and Ni and may have a thickness of 0.01 mm to 0.3 mm. When the thickness of the lower electrode 120 or the upper electrode 150 is less than 0.01 mm, an electrode function thereof is degraded such that electric conductivity performance thereof may be lowered, and when the thickness thereof is greater than 0.3 mm, resistance thereof increases so that conduction efficiency thereof may be lowered.

In addition, the lower substrate 110 and the upper substrate 160 may be metal substrates opposite to each other, and a thickness of each of the lower substrate 110 and the upper substrate 160 may be in the range of 0.1 mm to 1.5 mm. When the thickness of the metal substrate is less than 0.1 mm or greater than 1.5 mm, since a heat radiation property or heat conduction rate may become excessively high, reliability of the thermoelectric device may be degraded. In addition, when the lower substrate 110 and the upper substrate 160 are the metal substrates, insulating layers 170 may be formed between the lower substrate 110 and the lower electrode 120 and between the upper substrate 160 and the upper electrode 150. The insulating layer 170 may include a material having a heat conductivity of 5 to 20 W/K.

In this case, sizes of the lower substrate 110 and the upper substrate 160 may also be different. For example, a volume, thickness, or area of one of the lower substrate 110 and the upper substrate 160 may be greater than that of the other thereof. Accordingly, heat absorption or radiation performance of the thermoelectric device may be improved. Preferably, at least any one of the volume, the thickness, and the area of the lower substrate 110 may be greater than the corresponding one of the upper substrate 160. In this case, when the lower substrate 110 is disposed in a high temperature region for the Seebeck effect, at least any one of the volume, the thickness, and the area of the lower substrate 110 may be greater than corresponding one of the upper substrate 160 when compared to a case in which the lower substrate 110 is applied to a heating region for the Peltier effect or a case in which the sealing member is disposed on the lower substrate 110 in order to protect a thermoelectric module, which will be described below, from an external environment. In this case, the area of the lower substrate 110 may be 1.2 to 5 times the area of the upper substrate 160. When the area of the lower substrate 110 is less than 1.2 times the area of the upper substrate 160, an effect on improvement of heat transfer efficiency is not high, and when the area of the lower substrate 110 is greater than 1.2 times the area of the upper substrate 160, the heat transfer efficiency is reduced rather remarkably, and it may be difficult to maintain a basic shape of the thermoelectric module.

In addition, a heat radiation pattern, for example, a concave-convex pattern, may be formed on a surface of at least one of the lower substrate 110 and the upper substrate 160. Accordingly, heat radiation performance of the thermoelectric device may be improved. When the concave-convex pattern is formed on the surface in contact with the P-type thermoelectric leg 130 or the N-type thermoelectric leg 140, a bonding property between the thermoelectric leg and the substrate may be improved. The thermoelectric device 100 includes the lower substrate 110, the lower electrodes 120, the P-type thermoelectric legs 130, the N-type thermoelectric legs 140, the upper electrodes 150, and the upper substrate 160.

As illustrated in FIGS. 3 and 4, a sealing member 190 may be further disposed between the lower substrate 110 and the upper substrate 160. The sealing member may be disposed on side surfaces of the lower electrode 120, the P-type thermoelectric leg 130, the N-type thermoelectric leg 140, and the upper electrode 150 between the lower substrate 110 and the upper substrate 160. Accordingly, the lower electrode 120, the P-type thermoelectric leg 130, the N-type thermoelectric leg 140, and the upper electrode 150 may be sealed from moisture, heat, and contamination from the outside. In this case, the sealing member 190 may include a sealing case 192 disposed to be spaced apart from outermost side surfaces of the plurality of lower electrodes 120, the plurality of P-type thermoelectric legs 130 and the plurality of N-type thermoelectric legs 140, and the plurality of upper electrodes 150 by a predetermined distance, a sealing material 194 disposed between the sealing case 192 and the lower substrate 110, and a sealing material 196 disposed between the sealing case 192 and the upper substrate 160. As described above, the sealing case 192 may be in contact with the lower substrate 110 and the upper substrate 160 through the sealing materials 194 and 196. Accordingly, a problem in that heat conduction occurs through the sealing case 192 and thus a temperature difference between the lower substrate 110 and the upper substrate 160 decreases when the sealing case 192 is in direct contact with the lower substrate 110 and the upper substrate 160 may be prevented. In this case, each of the sealing materials 194 and 196 may include at least one of an epoxy resin and a silicone resin or a tape of which both surfaces are coated with at least one of an epoxy resin and a silicone resin. The sealing materials 194 and 194 may respectively serve to airtightly seal a gap between the sealing case 192 and the lower substrate 110 and a gap between the sealing case 192 and the upper substrate 160, may improve a sealing effect of the lower electrode 120, the P-type thermoelectric leg 130, the N-type thermoelectric leg 140, and the upper electrode 150 and may be interchangeably used with a finishing material, a finishing layer, a waterproofing material, a waterproofing layer, and the like. In this case, the sealing material 194, which seals the gap between the sealing case 192 and the lower substrate 110, may be disposed on the lower substrate 110, and the sealing material 196, which seals the gap between the sealing case 192 and the upper substrate 160, may be disposed on a side surface of the upper substrate 160. To this end, the area of the lower substrate 110 may be greater than the area of the upper substrate 160. Meanwhile, guide grooves G, through which lead wires 180 and 182 connected to the electrodes extend, may be formed in the sealing case 192. To this end, the sealing case 192 may be an injection molding part formed of plastic and may be interchangeably used with a sealing cover. An insulator may be further included to surround the sealing member. Alternatively, the sealing member may further include an insulating component.

Meanwhile, the P-type thermoelectric leg 130 and the N-type thermoelectric leg 140 may have a structure illustrated in FIG. 1A or 1B. Referring to FIG. 1A, the thermoelectric legs 130 and 140 may respectively include thermoelectric material layers 132 and 142, first plated layers 134-1 and 144-1 stacked on one surfaces of the thermoelectric material layers 132 and 142, and second plated layers 134-2 and 144-2 stacked on the other surfaces, which are disposed opposite to the one surfaces, of the thermoelectric material layers 132 and 142. Alternatively, referring to FIG. 1B, the thermoelectric legs 130 and 140 may respectively include thermoelectric material layers 132 and 142, first plated layers 134-1 and 144-1 stacked on one surfaces of the thermoelectric material layers 132 and 142, second plated layers 134-2 and 144-2 stacked on the other surface, which are disposed opposite to the one surfaces, of the thermoelectric material layers 132 and 142, first buffer layers 136-1 and 146-1 disposed between the thermoelectric material layers 132 and 142 and the first plated layers 134-1 and 144-1, and second buffer layers 136-2 and 146-2 disposed between the thermoelectric material layers 132 and 142 and the second plated layers 134-2 and 144-2. Alternatively, the thermoelectric legs 130 and 140 may further include metal layers stacked between the first plated layers 134-1 and 144-1 and the lower substrate 110 and metal layers stacked between the second plated layers 134-2 and 144-2 and the upper substrate 160, respectively.

In this case, each of the thermoelectric material layers 132 and 142 may include Bi and Te which are semiconductor materials. Materials or shapes of the thermoelectric material layers 132 and 142 may be the same as the above-described material or shape of the P-type thermoelectric leg 130 or the N-type thermoelectric leg 140. When thermoelectric material layers 132 and 142 are polycrystalline layers, a bonding force between the thermoelectric material layers 132 and 142 and the first buffer layers 136-1 and 146-1 and the first plated layers 134-1 and 144-1 and a bonding force between the thermoelectric material layers 132 and 142 and the second buffer layers 136-2 and 146-2 and the second plated layers 134-2 and 144-2 may increase. Accordingly, even when the thermoelectric device 100 is applied to an application, for example, a vehicle in which vibration occurs, a problem, in that the first plated layers 134-1 and 144-1 and the second plated layers 134-2 and 144-2 are separated from the P-type thermoelectric leg 130 or the N-type thermoelectric leg 140 and carbonized, may be prevented, and durability and reliability of the thermoelectric device 100 may be improved.

In addition, the metal layer may include Cu, a Cu alloy, Al, or an Al alloy and may have a thickness of 0.1 to 0.5 mm and preferably 0.2 to 0.3 mm.

Next, each of the first plated layers 134-1 and 144-1 and the second plated layers 134-2 and 144-2 may include at least one of Ni, Sn, Ti, Fe, Sb, Cr, and Mo and may have a thickness of 1 to 20 $\mu$m and preferably 1 to 10 $\mu$m. Since the first plated layers 134-1 and 144-1 and the second plated layers 134-2 and 144-2 prevent reactions between Bi or Te, which are semiconductor materials in the thermoelectric material layers 132 and 142, and the metal layers, the first plated layers 134-1 and 144-1, and the second plated layers 134-2 and 144-2 may prevent not only performance degradation of the thermoelectric device but also oxidation of the metal layers.

In this case, the first buffer layers 136-1 and 146-1 may be disposed between the thermoelectric material layers 132 and 142 and the first plated layers 134-1 and 144-1, and the second buffer layers 136-2 and 146-2 may be disposed between the thermoelectric material layers 132 and 142 and the second plated layers 134-2 and 144-2. In this case, each of the first buffer layers 136-1 and 146-1 and the second buffer layers 136-2 and 146-2 may include Te. For example, each of the first buffer layers 136-1 and 146-1 and the second buffer layers 136-2 and 146-2 may include at least one among Ni-Te, Sn-Te, Ti-Te, Fe-Te, Sb-Te, Cr-Te, and Mo-Te. According to the embodiment of the present invention, when the first buffer layers 136-1 and 146-1 each including Te are disposed between the thermoelectric material layers 132 and 142 and the first plated layers 134-1 and 144-1, and when the second buffer layers 136-2 and 146-2 each including Te are disposed between the thermoelectric material layers 132 and 142 and the second plated layers 134-2 and 144-2, Te in the thermoelectric material layers 132 and 142 may be prevented from being diffused into the first plated layers 134-1 and 144-1 and the second plated layers 134-2 and 144-2. Accordingly, a problem in that an electric resistance increases in the thermoelectric material layer due to a Bi rich region may be prevented.

As described above, although the terms, such as the lower substrate 110, the lower electrode 120, the upper electrode 150, and the upper substrate 160, have been used, "upper" and "lower" are arbitrarily used only for the sake of ease of understanding and convenience of description, and positions thereof may also be reversed so that the lower substrate 110 and the lower electrode 120 are disposed in upper portions, and the upper electrode 150 and the upper substrate 160 are disposed in lower portions.

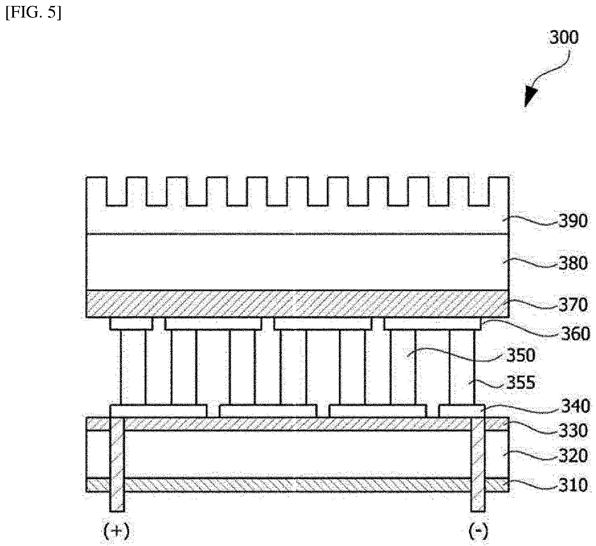

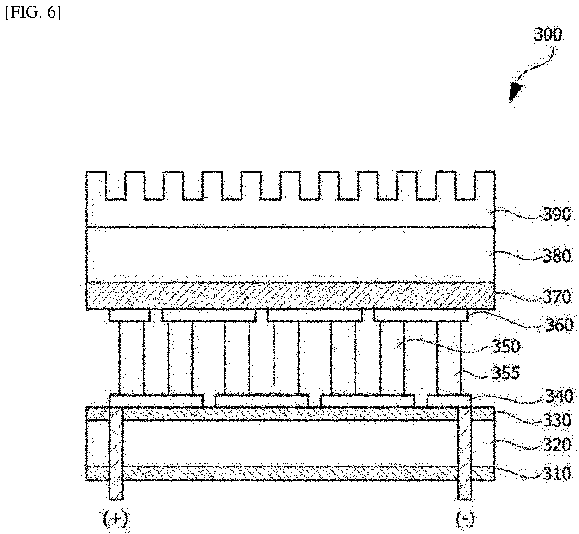

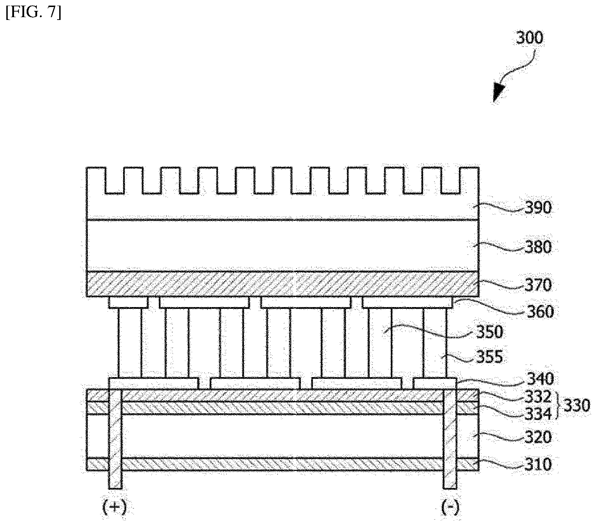

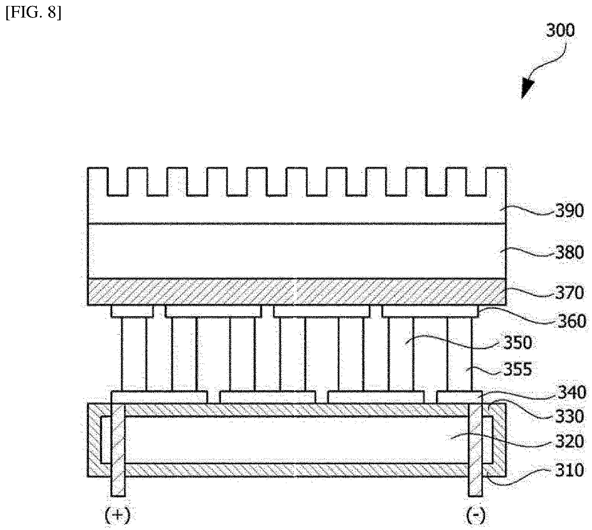

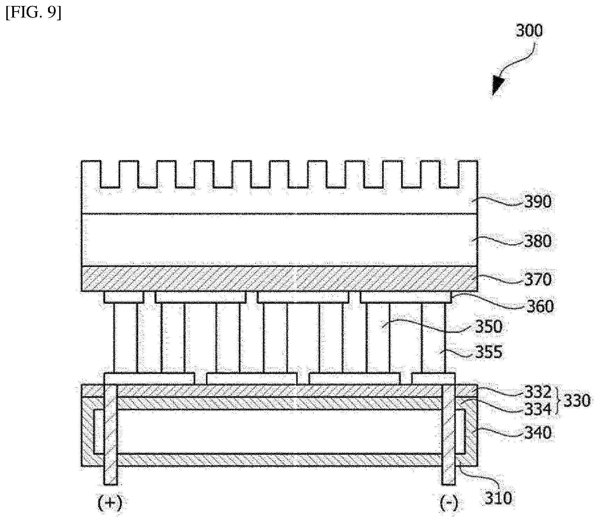

FIG. 5 is a cross-sectional view illustrating a thermoelectric device according to one embodiment of the present invention, FIG. 6 is a cross-sectional view illustrating a thermoelectric device according to another embodiment of the present invention, FIG. 7 is a cross-sectional view illustrating a thermoelectric device according to still another embodiment of the present invention, FIG. 8 is a cross-sectional view illustrating a thermoelectric device according to yet another embodiment of the present invention, and FIG. 9 is a cross-sectional view illustrating a thermoelectric device according to yet another embodiment of the present invention. Repeated descriptions about contents which are the same as the contents described with reference to FIGS. 1 to 4 will be omitted.

Referring to FIGS. 5 to 7, a thermoelectric device 300 according to the embodiments of the present invention includes a first insulating layer 310, a first substrate 320 disposed on the first insulating layer 310, a second insulating layer 330 disposed on the first substrate 320, a plurality of first electrodes 340 disposed on the second insulating layer 330, a plurality of P-type thermoelectric legs 350 and a plurality of N-type thermoelectric legs 355 disposed on the plurality of first electrodes 340, a plurality of second electrodes 360 disposed on the plurality of P-type thermoelectric legs 350 and the plurality of N-type thermoelectric legs 355, a third insulating layer 370 disposed on the plurality of second electrodes 360, and a second substrate 380 disposed on the third insulating layer 370. As illustrated in the drawings, a heat sink 390 may be further disposed on the second substrate 380. Although not illustrated in the drawings, a sealing member may be further disposed between the first substrate 320 and the second substrate 380.

In this case, the first electrode 340, the P-type thermoelectric leg 350, the N-type thermoelectric leg 360, and the second electrode 370 may respectively correspond to the upper electrode 150, the P-type thermoelectric leg 130, the N-type thermoelectric leg 140, and the lower electrode 120 which have been described with reference to FIGS. 1 and 2, and contents thereof may be the same or similar to the contents described with reference to FIGS. 1 and 2.

Generally, since a power source is connected to the electrode disposed at a low temperature portion side of the thermoelectric device 300, higher withstand voltage performance may be required at a high temperature portion side than the low temperature portion side. In this case, it is illustrated that a positive (+) terminal and a negative (-) terminal are connected to the first electrodes 340, pass through the first insulating layer 310, the first substrate 320, and the second insulating layer 330, and extend downward, but the present invention is not limited thereto, and the positive (+) terminal and the negative (-) terminal may be connected to the first electrodes 340 and may laterally extend on the first insulating layer 310, the first substrate 320, and the second insulating layer 330.

Conversely, when the thermoelectric device 300 is driven, since the high temperature portion side of the thermoelectric device 300 may be exposed to a high temperature, for example, about 180 °C or more, there may be a problem of delamination between the electrodes, the insulating layer, and the substrate due to differences in thermal expansion coefficient between the electrodes, the insulating layer, and the substrate. Accordingly, higher heat conduction performance may be required at the high temperature portion side of the thermoelectric device 300 than the low temperature portion side thereof. Particularly, when the heat sink is further disposed on the substrate at the high temperature portion side of the thermoelectric device 300, a bonding force between the substrate and the heat sink may greatly affect durability and reliability of the thermoelectric device 300.

Hereinafter, it will be assumed and described that the first substrate 320 is disposed at the low temperature portion side of the thermoelectric device 300 and that the second substrate 380 is disposed at the high temperature portion side of the thermoelectric device 300.

According to the embodiment of the present invention, the first substrate 320 is formed as an aluminum substrate, and the second substrate 380 is formed as a copper substrate. The copper substrate has higher heat conductivity and electric conductivity than the aluminum substrate. Accordingly, when the first substrate 320 is formed as the aluminum substrate, and the second substrate 380 is formed as the copper substrate, both of high withstand voltage performance of the low temperature portion side and high heat radiation performance of the high temperature portion side may be satisfied.

In addition, the first substrate 320 is disposed on the first insulating layer 310, and the second insulating layer 330 is disposed on the first substrate 320. As described above, when the insulating layers are disposed on both surfaces of the first substrate 320, withstand voltage performance at a side of the first substrate 320 may be further improved.

In this case, the first insulating layer 310 includes an aluminum oxide layer. When the first insulating layer 310 is the aluminum oxide layer, the withstand voltage performance at the side of the first substrate 320 may be improved even without increasing thermal resistance thereof. In this case, a thickness of the first insulating layer 310 may be in the range of 20 to 100 $\mu$m, preferably 30 to 80 $\mu$m, and more preferably 35 to 60 $\mu$m. When the thickness of the first insulating layer 310 satisfies the numerical ranges, high heat conduction performance and the high withstand voltage performance may be satisfied at the same time.

In this case, a total sum of thicknesses of the insulating layers at the side of the first substrate 320, that is, the sum of the thickness of the first insulating layer 310 and a thickness of the second insulating layer 330, may be 80 $\mu$m or more and more preferably 80 to 480 $\mu$m. Generally, as the thickness of the insulating layer increases, withstand voltage performance may be improved. However, as the thickness of the insulating layer increases, there is a problem of increasing thermal resistance. However, in the embodiment of the present invention, as the insulating layers at the side of the first substrate 320 are separately disposed at both sides of the first substrate 320, and particularly, the aluminum oxide layer is disposed under the first substrate 320, the high heat conduction performance and the high withstand voltage performance may be satisfied at the same time.

Meanwhile, as illustrated in FIG. 3, each of the second insulating layer 330 and the third insulating layer 370 includes a resin layer including at least one of an epoxy resin composition which may include an epoxy resin and an inorganic filler and a silicone resin composition which may include a polydimethylsiloxane (PDMS). Accordingly, the second insulating layer 330 may improve an insulation property, a bonding force, and heat conduction performance between the first substrate 320 and the first electrode 340, and the third insulating layer 370 may improve an insulation property, a bonding force, and heat conduction performance between the second electrode 360 and the second substrate 380.

In this case, the inorganic filler may be included in the resin layer at 68 to 88 vol% of the resin layer. When the inorganic filler is included therein at less than 68 vol% thereof, a heat conduction effect may be low, and when the inorganic filler is included therein at greater than 88 vol%, the resin layer may break easily.

In addition, the epoxy resin may include an epoxy compound and a hardener. In this case, the hardener may be included in the range of 1 to 10 volume ratio based on 10 volume ratio of the epoxy compound. In this case, the epoxy compound may include at least one among a crystalline epoxy compound, an amorphous epoxy compound, and a silicone epoxy compound. The inorganic filler may include aluminum oxide and nitride, and the nitride may be included therein at 55 to 95 wt% of the inorganic filler and more preferably at 60 to 80 wt% thereof. When the nitride is included therein in the numerical range, heat conductivity and a bonding force may be improved. In this case, the nitride may include at least one of boron nitride and aluminum nitride.

In this case, a particle size D50 of a boron nitride aggregate may be in the range of 250 to 350 $\mu$m, and a particle size D50 of the aluminum oxide may be in the range of 10 to 30 $\mu$m. When the particle size D50 of the boron nitride aggregate satisfies the numerical value, and the particle size D50 of the aluminum oxide satisfies the numerical value, the boron nitride aggregate and the aluminum oxide may be uniformly distributed in the resin layer, and thus, the entire resin layer may have a uniform heat conduction effect and bonding performance.

In this case, in terms of heat conduction performance, it is advantageous for the second insulating layer 330 formed as the resin layer to be disposed as thinly as possible while maintaining insulation performance and bonding performance between the first substrate 320 and the first electrode 340. According to the embodiment of the present invention, since the first insulating layer 310 formed as the aluminum oxide layer is disposed with the second insulating layer 330 with the first substrate 320 interposed therebetween, the low temperature portion side may have sufficient withstand voltage performance even when the thickness of the second insulating layer 330 formed as the resin layer is equal to or smaller than a thickness of the third insulating layer 370 formed of the material which is the same as the material of the second insulating layer 330. Accordingly, the thickness of the second insulating layer 330 formed as the resin layer may be equal to or smaller than the thickness of the third insulating layer 370.

Particularly, the thickness of the third insulating layer 370 may be greater than the thickness of the second insulating layer 330. As described above, when the thermoelectric device 300 is driven, a temperature of the high temperature portion side may raise to about 180 °C or more, and when the third insulating layer 370 is formed as the flexible resin layer according to the embodiment of the present invention, the third insulating layer 370 may serve to relieve thermal shock between the second electrode 360 and the second substrate 380.

Meanwhile, referring to FIG. 6, the second insulating layer 330 may include a second aluminum oxide layer, and the third insulating layer 370 may be formed as the resin layer including at least one of the epoxy resin composition including the epoxy resin and the inorganic filler and the silicone resin composition including the PDMS. As described above, at the low temperature portion side, withstand voltage performance is more important, and at the high temperature portion side, bonding performance is more important. Accordingly, when the second insulating layer 330 is formed as the second aluminum oxide layer, the second insulating layer 330 may have higher withstand voltage performance when compared to a case in which the second insulating layer 330 is formed as the resin layer. In addition, when the third insulating layer 370 is formed as the resin layer, bonding performance between the second electrode 360 and the second substrate 380 may be ensured.

Alternatively, referring to FIG. 7, the second insulating layer 330 includes a second aluminum oxide layer 334 disposed on the first substrate 320 and may also further include a resin layer 332 disposed on the second aluminum oxide layer 334. In this case, the resin layer 332 included in the second insulating layer 330 may increase a bonding force between the second aluminum oxide layer 334 and the first electrode 340. That is, since the resin layer 332 included in the second insulating layer 330 is formed to only provide the bonding force between the second aluminum oxide layer 334 and the first electrode 340, a thickness of the resin layer 332 of the second insulating layer 330 may be smaller than each of a thickness of the second aluminum oxide layer 334 and the thickness of the third insulating layer 370.

As described above, according to the embodiment of the present invention, the thermoelectric device, in which the structure of the substrate and the insulating layer is changed to correspond to a difference in characteristic between a low temperature portion and a high temperature portion of the thermoelectric device, may be obtained.

**In** this case, at least one of a first aluminum oxide layer 312 and the second aluminum oxide layer 334 may be formed by anodizing the aluminum substrate which is the first substrate 320. Alternatively, at least one of the first aluminum oxide layer 312 and the second aluminum oxide layer 334 may also be formed using a dipping process or spray process.

Meanwhile, as illustrated in FIGS. 8 and 9, an extension part 340 formed to extend from at least one of the first aluminum oxide layer 312 and the second aluminum oxide layer 334 along the aluminum substrate, which is the first substrate 320, may connect the first aluminum oxide layer 312 and the second aluminum oxide layer 334 at a side surface of the aluminum substrate. Accordingly, the aluminum oxide layer may be formed on an entire surface of the aluminum substrate, and withstand voltage performance of the low temperature portion side may be further improved.

Meanwhile, as described above, the heat sink may be further disposed at the high temperature portion side. The second substrate 380 and the heat sink 390 of the high temperature portion side may be integrally formed, but the separate second substrate 380 and heat sink 390 may also be bonded. In this case, when a metal oxide layer is formed on the second substrate 380, it may be difficult to bond the second substrate 380 and the heat sink 390. Accordingly, in order to increase bonding strength between the second substrate 380 and the heat sink 390, the metal oxide layer may not be formed between the second substrate 380 and the heat sink 390. That is, when the second substrate 380 is the copper substrate, a copper oxide layer may not be formed on the copper substrate. To this end, a surface treatment may be performed on the copper substrate in advance to prevent the copper substrate from being oxidized. For example, when the copper substrate is plated with a metal layer of nickel having a property which is not easily oxidized when compared to the copper, the metal oxide layer may be prevented from being formed on the copper substrate.

As described above, according to the embodiment of the present invention, the thermoelectric device, in which the structure of the substrate and the insulating layer of the low temperature portion side and the structure of the substrate and the insulating layer of the high temperature portion side are different to correspond to a difference in characteristic between the low temperature portion and the high temperature portion of the thermoelectric device, may be obtained.

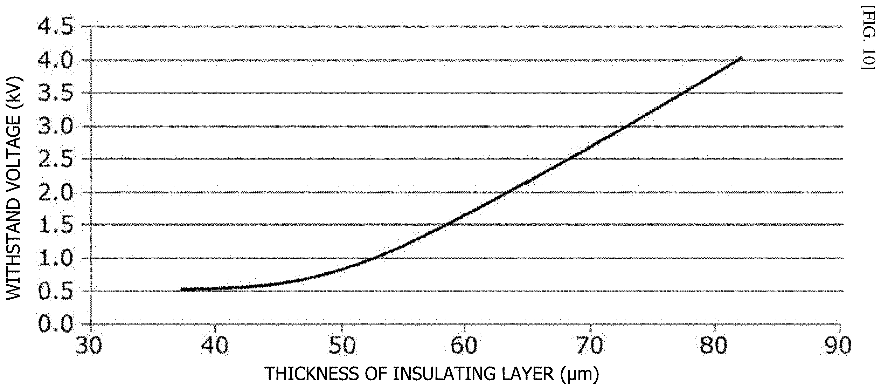

Table 1 and FIG. 10 show a result of simulating a withstand voltage according the thickness of the insulating layer. The insulating layer is formed by anodizing the aluminum substrate, and the withstand voltage is measured according to the thickness of insulating layer.

[Table 1]

| Thickness of Insulating Layer ($\mu$m) | Withstand Voltage (kV) |
| --- | --- |
| 37 | 0.5 |
| 53 | 1.0 |
| 82 | 3.6 |

Referring to Table 1 and FIG. 10, it may be seen that, as the thickness of the insulating layer increases, withstand voltage performance is improved. Particularly, when the thickness of the insulating layer is 80 $\mu$m or more, withstand voltage performance of 3.6 kV or more can be obtained.

Table 2 shows a result of measuring a thermal resistance of each thermoelectric device according to Comparative Example and Examples.

In Comparative Example, an insulating layer formed as a resin layer is disposed on a copper substrate, in Example 1, the aluminum substrate is disposed on the aluminum oxide layer, and the insulating layer formed as the resin layer is further disposed thereon, in Example 2, the aluminum oxide layers are disposed on both surfaces of the aluminum substrate, and in Example 3, the aluminum oxide layers are formed on both surfaces of the aluminum substrate, and the insulating layer formed as the resin layer is further disposed thereon.

[Table 2]

| Experiment Number | Structure | Heat Conductivity (W/mK) | Thickness ($\mu$m) | Heat Transmission Coefficient (W/m$^2$K) | Thermal Resistance m$^2$K/W |
|---|---|---|---|---|---|
| Comparative Example | Resin Layer | 2 | 40 | 47,500 | 0.000021 |
| | Copper Substrate | 400 | 3,000 | 133,333 | 0.000008 |
| | Sum | | | | 0.0000286 |
| Example 1 | Resin Layer | 1.9 | 25 | 76,000 | 0.000013 |
| | Aluminum Substrate | 237 | 3000 | 79,000 | 0.000013 |
| | Aluminum Oxide Layer | 30 | 55 | 545,455 | 0.000002 |
| | Sum | | | | 0.0000276 |
| Example 2 | Aluminum Oxide layer | 30 | 40 | 750,000 | 0.000001 |
| | Aluminum Substrate | 237 | 3,000 | 79,000 | 0.000013 |
| | Aluminum Oxide Layer | 30 | 40 | 750,000 | 0.000001 |
| | SUM | | | | 0.0000153 |
| Example 3 | Resin Layer | 2 | 5 | 380,000 | 0.000003 |
| | Aluminum Oxide Layer | 30 | 40 | 750,000 | 0.000001 |
| | Aluminum Substrate | 237 | 3,000 | 79,000 | 0.000013 |
| | Aluminum Oxide Layer | 30 | 40 | 750,000 | 0.000001 |
| | Sum | | | | 0.0000180 |

Referring to Table 2, in Comparative Example, it may be seen that, although a total thickness of the insulating layer is 40 $\mu$m which is smaller than a total thickness of each of the insulating layers of Examples 1 to 3, the insulating layer has a higher thermal resistance than each of the insulating layers of Examples 1 to 3. In addition, it may be seen that each of the thermal resistances in Examples 2 and 3 in which the aluminum oxide layers are disposed on both surfaces of the aluminum substrate is significantly lower than the thermal resistance in Example 1 in which the aluminum oxide layer is disposed on only one surface of the aluminum substrate. In addition, in the case of Example 3 in which the resin layer is further disposed on the aluminum oxide layer, although the thermal resistance is similar, bonding performance between the aluminum substrate and the electrode may be higher when compared to the Example 2.

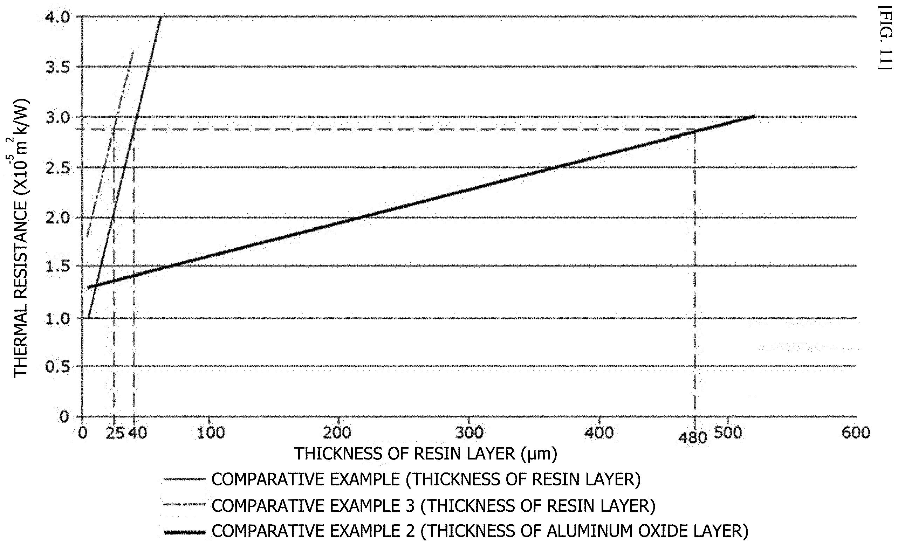

Meanwhile, FIG. 11 shows a result of simulating a thermal resistance according to a thickness of the insulating layer in each structure according to Comparative Example, Example 2, and Example 3.

Referring to FIG. 11, in each of the structures of Comparative Example and Example 3, it may be seen that as the thickness of the resin layer increases, the thermal resistance increases sharply. Conversely, in the structure according to Example 2, it may be seen that, even when the thickness of the aluminum oxide layer increases to 480 $\mu$m, the thermal resistance of which a level is a level when the thickness of the resin layer is 40 $\mu$m is obtained.

The thermoelectric device according to the embodiment of the present may be applied to power generation apparatuses, cooling apparatuses, heating apparatuses, and the like. Specifically, the thermoelectric device according to the embodiment of the present invention may be mainly applied to optical communication modules, sensors, medical apparatuses, measuring instruments, aerospace industries, refrigerators, chillers, automobile ventilation seats, cup holders, washing machines, dryers, wine cellars, water purifiers, power supplies for sensors, thermopiles, and the like.

In this case, as examples of the thermoelectric device according to the embodiments of the present invention applied to the medical apparatuses, there are polymerase chain reaction (PCR) apparatuses. The PCR apparatus is an apparatus which is for determining the nucleotide sequence of deoxyribonucleic acid (DNA) by amplifying DNA and in which precise temperature control and thermal cycle are required. To this end, a Peltier-based thermoelectric device may be applied thereto.

As other examples of the thermoelectric device according to the embodiments of the present invention applied to the medical apparatuses, there are photo detectors. In this case, the photo detectors may include infrared/ultraviolet detectors, charge coupled apparatus (CCD) sensors, X-ray detectors, thermoelectric thermal reference sources (TTRSs), and the like. A Peltier-based thermoelectric device may be applied to cooling a photo detector. Accordingly, a change in wavelength, output degradation, and resolution degradation due to an increase in temperature in the photo detector may be prevented.

As still other examples of the thermoelectric device according to the embodiments of the present invention applied to the medical apparatuses, there are immunoassay fields, in vitro diagnostics fields, general temperature control and cooling systems, physical therapy fields, liquid chiller systems, blood/plasma temperature control fields, and the like. Accordingly, precise temperature control may be performed.

As still other examples of the thermoelectric device according to the embodiments of the present invention applied to the medical apparatuses, there are artificial hearts. Accordingly, power may be applied to the artificial heart.

As examples of the thermoelectric device according to the embodiments of the present invention applied to the aerospace industries, there are star tracking systems, thermal imaging cameras, infrared/ultraviolet detectors, CCD sensors, the Hubble Space Telescope, TTRSs, and the like. Accordingly, a temperature of an image sensor may be maintained.

As other examples of the thermoelectric device according to the embodiments of the present invention applied to the aerospace industries, there are cooling apparatuses, heaters, power generation apparatuses, and the like.

In addition, the thermoelectric device according to the embodiments of the present invention may be applied to generating power, cooling, and heating in other industries.

## Claims

1. A thermoelectric device (300) comprising:

   a first insulating layer (310);
   a first substrate (320) disposed on the first insulating layer (310);
   a second insulating layer (330) disposed on the first substrate (320);
   a first electrode (340) disposed on the second insulating layer (330);
   a P-type thermoelectric leg (350) and an N-type thermoelectric leg (355) disposed on the first electrode (340);
   a second electrode (360) disposed on the P-type thermoelectric leg (350) and the N-type thermoelectric leg (355);
   a third insulating layer (370) disposed on the second electrode (360); and
   a second substrate (380) disposed on the third insulating layer (370),
   wherein the first insulating layer (310) includes a first aluminum oxide layer,
   the first substrate (320) includes an aluminum substrate,
   the second substrate (380) includes a copper substrate,
   the first substrate (320) includes a low temperature portion, and
   the second substrate (380) includes a high temperature portion,
   wherein each of the second insulating layer (330) and the third insulating layer (370) is formed as a resin layer including at least one of an epoxy resin composition and a silicone resin composition.

2. The thermoelectric device of claim 1, wherein a thickness of the second insulating layer (330) is:

   equal to a thickness of the third insulating layer (370); or
   smaller than the thickness of the third insulating layer (370).

3. The thermoelectric device of claim 1, wherein:
   the second insulating layer (330) further includes a second aluminum oxide layer.

4. The thermoelectric device of claim 3, wherein the resin layer of the second insulating layer (330) is disposed on the second aluminum oxide layer.

5. The thermoelectric device of claim 4, wherein a thickness of the resin layer included in the second insulating layer (330) is smaller than each of a thickness of the second aluminum oxide layer and a thickness of the third insulating layer (370).

6. The thermoelectric device of claim 4, wherein at least one of the first aluminum oxide layer and the second aluminum oxide layer is formed by anodizing the aluminum substrate.

7. The thermoelectric device of claim 4, wherein at least one of the first aluminum oxide layer and the second aluminum oxide layer extends along a side surface of the aluminum substrate and is connected to the other one thereof.

8. The thermoelectric device of claim 1, wherein a sum of a thickness of the first insulating layer (310) and a thickness of the second insulating layer (330) is 80 μm or more.

9. The thermoelectric device of claim 1, further comprising a heat sink (390) disposed on the copper substrate.

10. The thermoelectric device of claim 9, wherein a copper oxide layer is not disposed between the copper substrate and the heat sink (390).

11. The thermoelectric device of claim 9, wherein at least portion of a surface of the copper substrate is plated with a nickel layer.

12. The thermoelectric device of claim 1, wherein a power source is connected to the first electrode (340).

13. The thermoelectric device of claim 12, wherein a positive terminal and a negative terminal of the power source are connected to the first electrode (340), and extend downward through the second insulating layer (330), the first substrate (320) and the first insulating layer (310).

14. The thermoelectric device of claim 12, wherein a positive terminal and a negative terminal of the power source are connected to the first electrode (340), and laterally extend on the first insulating layer (310), the first substrate (320) and the second insulating layer (330).

**Patentansprüche**

1. Thermoelektrische Vorrichtung (300), umfassend:

eine erste Isolierschicht (310);
ein erstes Substrat (320), das auf der ersten Isolierschicht (310) angeordnet ist;
eine zweite Isolierschicht (330), die auf dem ersten Substrat (320) angeordnet ist;
eine erste Elektrode (340), die auf der zweiten Isolierschicht (330) angeordnet ist;
einen thermoelektrischen Schenkel (350) vom Typ P und einen thermoelektrischen Schenkel (355) vom Typ N, die auf der ersten Elektrode (340) angeordnet sind;
eine zweite Elektrode (360), die auf dem thermoelektrischen Schenkel (350) vom Typ P und dem thermoelektrischen Schenkel (355) vom Typ N angeordnet ist;
eine dritte Isolierschicht (370), die auf der zweiten Elektrode (360) angeordnet ist; und ein zweites Substrat (380), das auf der dritten Isolierschicht (370) angeordnet ist,
wobei die erste Isolierschicht (310) eine erste Aluminiumoxidschicht enthält,
das erste Substrat (320) ein Aluminiumsubstrat enthält,
das zweite Substrat (380) ein Kupfersubstrat enthält,
das erste Substrat (320) einen Niedertemperaturabschnitt enthält, und
das zweite Substrat (380) einen Hochtemperaturabschnitt enthält,
wobei jede der zweiten Isolierschicht (330) und der dritten Isolierschicht (370) als Harzschicht ausgebildet ist, die eine Epoxidharzzusammensetzung und/oder eine Silikonharzzusammensetzung enthält.

2. Thermoelektrische Vorrichtung nach Anspruch 1, wobei eine Dicke der zweiten Isolierschicht (330) wie folgt ist:

gleich einer Dicke der dritten Isolierschicht (370); oder
kleiner als die Dicke der dritten Isolierschicht (370).

3. Thermoelektrische Vorrichtung nach Anspruch 1, wobei:
die zweite Isolierschicht (330) ferner eine zweite Aluminiumoxidschicht enthält.

4. Thermoelektrische Vorrichtung nach Anspruch 3, wobei die Harzschicht der zweiten Isolierschicht (330) auf der zweiten Aluminiumoxidschicht angeordnet ist.

5. Thermoelektrische Vorrichtung nach Anspruch 4, wobei eine Dicke der in der zweiten Isolierschicht (330) enthaltenen Harzschicht kleiner ist als jeweils eine Dicke der zweiten Aluminiumoxidschicht und eine Dicke der dritten Isolierschicht (370).

6. Thermoelektrische Vorrichtung nach Anspruch 4, wobei die erste Aluminiumoxidschicht und/oder die zweite Aluminiumoxidschicht durch Anodisieren des Aluminiumsubstrats gebildet wird.

7. Thermoelektrische Vorrichtung nach Anspruch 4, wobei sich die erste Aluminiumoxidschicht und/oder die zweite Aluminiumoxidschicht entlang einer Seitenfläche des Aluminiumsubstrats erstreckt und mit der anderen davon verbunden ist.

8. Thermoelektrische Vorrichtung nach Anspruch 1, wobei eine Summe aus einer Dicke der ersten Isolierschicht (310) und einer Dicke der zweiten Isolierschicht (330) 80 $\mu$m oder mehr beträgt.

9. Thermoelektrische Vorrichtung nach Anspruch 1, ferner umfassend einen auf dem Kupfersubstrat angeordneten Kühlkörper (390).

10. Thermoelektrische Vorrichtung nach Anspruch 9, wobei zwischen dem Kupfersubstrat und dem Kühlkörper (390) keine Kupferoxidschicht angeordnet ist.

11. Thermoelektrische Vorrichtung nach Anspruch 9, wobei mindestens ein Teil einer Oberfläche des Kupfersubstrats mit einer Nickelschicht beschichtet ist.

12. Thermoelektrische Vorrichtung nach Anspruch 1, wobei eine Stromquelle mit der ersten Elektrode (340) verbunden ist.

13. Thermoelektrische Vorrichtung nach Anspruch 12, wobei ein Pluspol und ein Minuspol der Stromquelle mit der ersten Elektrode (340) verbunden sind und sich nach unten durch die zweite Isolierschicht (330), das erste Substrat (320) und die erste Isolierschicht (310) erstrecken.

14. Thermoelektrische Vorrichtung nach Anspruch 12, wobei ein Pluspol und ein Minuspol der Stromquelle mit der ersten Elektrode (340) verbunden sind und sich seitlich auf der ersten Isolierschicht (310), dem ersten Substrat (320) und der zweiten Isolierschicht (330) erstrecken.

**Revendications**

1. Dispositif thermoélectrique (300) comprenant :

   une première couche isolante (310) ;
   un premier substrat (320) disposé sur la première couche isolante (310) ;
   une deuxième couche isolante (330) disposée sur le premier substrat (320) ;
   une première électrode (340) disposée sur la deuxième couche isolante (330) ;
   une patte thermoélectrique de type P (350) et une patte thermoélectrique de type N (355) disposées sur la première électrode (340) ;
   une deuxième électrode (360) disposée sur la patte thermoélectrique de type P (350) et la patte thermoélectrique de type N (355) ;
   une troisième couche isolante (370) disposée sur la deuxième électrode (360) ; et
   un deuxième substrat (380) disposé sur la troisième couche isolante (370),
   dans lequel la première couche isolante (310) comporte une première couche d'oxyde d'aluminium,
   le premier substrat (320) comporte un substrat d'aluminium,
   le deuxième substrat (380) comporte un substrat de cuivre,
   le premier substrat (320) comporte une partie à basse température, et
   le deuxième substrat (380) comporte une partie à haute température,
   dans lequel chacune de la deuxième couche isolante (330) et de la troisième couche isolante (370) se présente sous la forme d'une couche de résine comportant au moins une parmi une composition de résine époxy et une composition de résine de silicone.

2. Dispositif thermoélectrique selon la revendication 1, dans lequel une épaisseur de la deuxième couche isolante (330) est :

   égale à une épaisseur de la troisième couche isolante (370) ; ou

inférieure à l'épaisseur de la troisième couche isolante (370).

3.  Dispositif thermoélectrique selon la revendication 1, dans lequel :
    la deuxième couche isolante (330) comporte en outre une deuxième couche d'oxyde d'aluminium.

4.  Dispositif thermoélectrique selon la revendication 3, dans lequel la couche de résine de la deuxième couche isolante (330) est disposée sur la deuxième couche d'oxyde d'aluminium.

5.  Dispositif thermoélectrique selon la revendication 4, dans lequel une épaisseur de la couche de résine incluse dans la deuxième couche isolante (330) est inférieure à chacune d'une épaisseur de la deuxième couche d'oxyde d'aluminium et d'une épaisseur de la troisième couche isolante (370).

6.  Dispositif thermoélectrique selon la revendication 4, dans lequel au moins une parmi la première couche d'oxyde d'aluminium et la deuxième couche d'oxyde d'aluminium est formée par anodisation du substrat d'aluminium.

7.  Dispositif thermoélectrique selon la revendication 4, dans lequel au moins une parmi la première couche d'oxyde d'aluminium et la deuxième couche d'oxyde d'aluminium s'étend le long d'une surface latérale du substrat d'aluminium et est connectée à l'autre parmi celles-ci.

8.  Dispositif thermoélectrique selon la revendication 1, dans lequel une somme d'une épaisseur de la première couche isolante (310) et d'une épaisseur de la deuxième couche isolante (330) est de 80 $\mu$m ou plus.

9.  Dispositif thermoélectrique selon la revendication 1, comprenant en outre un dissipateur thermique (390) disposé sur le substrat de cuivre.

10. Dispositif thermoélectrique selon la revendication 9, dans lequel une couche d'oxyde de cuivre n'est pas disposée entre le substrat de cuivre et le dissipateur thermique (390).

11. Dispositif thermoélectrique selon la revendication 9, dans lequel au moins une partie d'une surface du substrat de cuivre est plaquée d'une couche de nickel.

12. Dispositif thermoélectrique selon la revendication 1, dans lequel une source d'alimentation est connectée à la première électrode (340).

13. Dispositif thermoélectrique selon la revendication 12, dans lequel une borne positive et une borne négative de la source d'alimentation sont connectées à la première électrode (340), et s'étendent vers le bas à travers la deuxième couche isolante (330), le premier substrat (320) et la première couche isolante (310).

14. Dispositif thermoélectrique selon la revendication 12, dans lequel une borne positive et une borne négative de la source d'alimentation sont connectées à la première électrode (340), et s'étendent latéralement sur la première couche isolante (310), le premier substrat (320) et la deuxième couche isolante (330).

[FIG. 1]

(a)         (b)

[FIG. 2]

[FIG. 3]

[FIG. 4]

[FIG. 5]

[FIG. 6]

[FIG. 7]

[FIG. 8]

[FIG. 9]

[FIG. 10]

[FIG. 11]

EP 3 982 431 B1

COMPARATIVE EXAMPLE (THICKNESS OF RESIN LAYER)

COMPARATIVE EXAMPLE 3 (THICKNESS OF RESIN LAYER)

COMPARATIVE EXAMPLE 2 (THICKNESS OF ALUMINUM OXIDE LAYER)

**EP 3 982 431 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20080089926 A
- JP 2009188088 A